# EUROPEAN PATENT SPECIFICATION

(11) **EP 3 499 252 B1**
(45) Date of publication and mention of the grant of the patent: **09.09.2020**
(21) Application number: 17868512.9
(22) Date of filing: 18.10.2017
(51) Int. Cl.: G01R 31/52, G01R 31/08

(54) **SINGLE-PHASE-TO-GROUND FAULT DETECTION METHOD AND DEVICE BASED ON MONITORING OF CHANGES OF ELECTRIC FIELD INTENSITIES**
VERFAHREN UND VORRICHTUNG FÜR EINPHASIGE ERDSCHLUSSDETEKTION AUF DER BASIS DER ÜBERWACHUNG VON ÄNDERUNGEN VON ELEKTRISCHEN FELDSTÄRKEN
PROCÉDÉ ET DISPOSITIF DE DÉTECTION DE DÉFAUTS MONOPHASÉS À LA TERRE BASÉS SUR LA SURVEILLANCE DES CHANGEMENTS D'INTENSITÉ DE CHAMP ÉLECTRIQUE

(43) Date of publication of application: 19.06.2019
(73) Proprietor: China Electric Power Research Institute Company Limited, Beijing 100192 (CN)
(72) Inventor: SHENG, Wanxing, Beijing 100192 (CN); SONG, Xiaohui, Beijing 100192 (CN); LI, Yajie, Beijing 100192 (CN); MENG, Xiaoli, Beijing 100192 (CN); GAO, Fei, Beijing 100192 (CN); LI, Jianfang, Beijing 100192 (CN); ZHANG, Yu, Beijing 100192 (CN); ZHAO, Shanshan, Beijing 100192 (CN)
(74) Representative: V.O.
(86) International application number: PCT/CN2017/106745
(87) International publication number: WO 2019/075673

(56) References cited:
- EP-A2- 2 733 498
- WO-A1-2004/040732
- WO-A1-2012/171694
- CN-A- 102 221 660
- CN-A- 102 221 660
- CN-A- 102 520 312
- CN-A- 102 540 012
- CN-A- 106 226 651
- CN-A- 106 370 975
- CN-A- 106 556 766
- CN-A- 106 707 084
- CN-A- 106 707 084
- CN-A- 106 771 870
- US-A1- 2011 227 581
- US-A1- 2016 061 873
- US-A1- 2016 187 389

## Description

### TECHNICAL FIELD

The disclosure relates to a fault detection technology in a distribution network, and particularly to a method, device and storage medium for single-phase ground fault detection based on monitoring of changes of electric field intensities.

### BACKGROUND

Low-current grounding is one of main grounding manners adopted for distribution networks in many countries, and in multiple faults occurring to a low-current grounding distribution network, a single-phase ground fault is one of faults occurring most frequently. Since a neutral point of a low-current grounding system is not directly grounded, impedance of a fault path formed by a single-phase ground fault is relatively higher, and a caused fault signature is not so obvious. In addition, due to the problems of interference of noise, influence of an operation condition (for example, asymmetry) of a distribution network and the like, there are still some shortcomings in terms of reliability and accuracy of detection over the single-phase ground fault of the low-current grounding system, although extensive researches have been made for long.

It is noted that patent publication CN 106707084A discloses a decision method for single-phase ground fault detection low-current grounding system. Further, it is noted that patent publication EP 2733498 A2 discloses a method for determining a fault phase during a single phase grounding fault and determining whether the fault is a downstream fault or a upstream fault. Moreover, it is noted that patent publication WO 2012/171694 A1 discloses a method for reliable detecting and monitoring of a multitude of different earth faults in three-phase electronic power distribution networks. Further relevant documents are CN 106771870 A, CN 102221660 A and US 2016/061873 A1.

### SUMMARY

In view of this, a method according to claim 1 and a device according to claim 4 for single-phase ground fault detection based on monitoring of changes of electric field intensities are provided, which can implement fault detection of a distribution network rapidly, accurately and reliably.

### BRIEF DESCRIPTION OF DRAWINGS

FIG. 1 is a first flowchart of a method for single-phase ground fault detection based on monitoring of changes of electric field intensities.
FIG. 2 is a second flowchart of a method for single-phase ground fault detection based on monitoring of changes of electric field intensities
FIG. 3 is a schematic diagram of an application scenario of the method for single-phase ground fault detection based monitoring of changes of electric field intensities.
FIG. 4 is a structure diagram of a device for single-phase ground fault detection based on monitoring of changes of electric field intensities.
FIG. 5 is a structure diagram of a device for single-phase ground fault detection based on monitoring of changes of electric field intensities.

### DETAILED DESCRIPTION

The inventor has found in researches that, at present, a single-phase ground fault is usually detected according to a zero-sequence voltage, and when a significant zero-voltage sequence lasting for a relatively longer time exists in a distribution network, it is determined that a permanent single-phase ground fault occurs in the network. However, such a manner has problems in two aspects. On one aspect, there is generally a phenomenon of three-phase imbalance in the distribution network, which may trigger a persistent zero-sequence voltage, and thus may be easily confused with a single-phase ground fault, and accuracy is not high enough. On the other aspect, the zero-sequence voltage in the distribution network is mostly acquired by an electromagnetic voltage transformer, and after occurrence of the single-phase ground fault, ferromagnetic resonance is easily triggered to impact security of a power grid.

At present, on the basis of different characteristic quantities according to which single-phase ground fault location is performed, methods may be classified into three types: a signal injection method, a steady state quantity location method and a transient state quantity location method. The signal injection method requires an additional signal device, and is complex in engineering implementation. The steady state quantity location method has the problems of weak characteristic signal and unreliable location result. A transient state characteristic adopted as a basis for the transient state quantity location method is several times and even dozens of times larger than a steady state value, and is not influenced by an arc suppression coil, so that higher application value is achieved; however, a transient state quantity exists for a relatively shorter time, so that it is difficult to capture the transient state quantity and extract a signal; in addition, transient state quantities of different locations are required to be compared for fault location, so that it highly depends on a communication technology; and therefore, an existing method still has the problem of low reliability in terms of implementation manner.

In the embodiments of the disclosure, changes of electric field intensities of three-phase feeders in a distribution network is monitored; and when the changes of the electric field intensities of the three-phase feeders are consistent with a preset electric field intensity change condition, it is determined that a single-phase ground fault occurs in the distribution network.

The disclosure will be further described below in combination with the drawings and the embodiments in detail. It is to be understood that the embodiments provided here are only adopted to explain the disclosure and not intended to limit the disclosure. In addition, the embodiments provided below are part of embodiments that can implement the disclosure, and not all embodiments implementing the disclosure are provided. The technical solutions recorded in the embodiments of the disclosure may be implemented in a free combination manner without conflicts.

It is to be noted that, in the embodiments of the disclosure, terms "include", "contain" or any other variant is intended to cover nonexclusive inclusions, so that a method or device including a series of elements not only includes the clearly recorded elements, but also includes other elements which are not clearly listed, or further includes elements intrinsic to the method or the device. Under the circumstance that there are no more limits, an element limited by a statement "including a/an......" does not exclude that there still exists another related element (for example, a step in a method or a unit in a device, the unit here may be a part of circuit, a part of processor, a part of program or software and the like, and of course, may also be a module) in a method or device including the element.

It is to be noted that terms "first/second/third" involved in the embodiments of the disclosure are adopted not to represent a specific sequence of objects but only to distinguish similar objects. It should be understood that a specific sequence or order of "first/second/third" may be exchanged, if allowed, for implementation of the embodiments of the disclosure described here in a sequence besides those shown or described here.

### Example

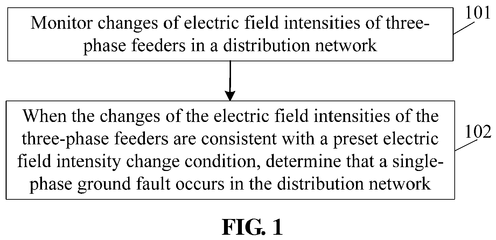

An example of the disclosure provides a method for single-phase ground fault detection based on monitoring of changes of electric field intensities. During a practical application, multiple devices for single-phase ground fault detection based on monitoring of changes of electric field intensities are distributed and arranged on three-phase feeders in a distribution network, the devices for single-phase ground fault detection based on monitoring of changes of electric field intensities may implement the distribution network fault detection method of the embodiment of the disclosure, and a layout of the devices for single-phase ground fault detection based on monitoring of changes of electric field intensities may be distribution and arrangement at a header end of a line and along the line. Referring to FIG. 1, the method for single-phase ground fault detection based on monitoring of changes of electric field intensities in the embodiment of the disclosure includes the following steps.

In Step 101, changes of electric field intensities of three-phase feeders in a distribution network is monitored.

In Step 102, when the changes of the electric field intensities of the three-phase feeders are consistent with a preset electric field intensity change condition, it is determined that a single-phase ground fault occurs in the distribution network.

Here, during practical implementation, a phase electric field signal may be picked up through an electric field sensor, a phase current signal may be picked up through a current transformer, and the like.

In an example changes condition of the electric field intensities of the three-phase feeders in the distribution network is acquired and monitored in real time, and when it is locally monitored that an electric field intensity of a first phase feeder is lower than a first field intensity threshold value (the first field intensity threshold value may be set according to a practical condition, and for example, is 50% of a normal electric field intensity of the feeder) and electric field intensities of a second phase feeder and a third phase feeder are higher than a second field intensity threshold value (the second field intensity threshold value is higher than the first field intensity threshold value, may be set according to the practical condition, and for example, is 1.5 times the normal electric field intensity of the feeder), it is determined that the single-phase ground fault occurs in the distribution network. That is, when it is recognized that an electric field of a certain phase in the three-phase feeders is significantly decreased and, meanwhile, the other two phases are significantly increased, the single-phase ground fault occurs in the distribution network.

Correspondingly, the phase of which the electric field intensity is lower than the first field intensity threshold value is a fault phase, and a moment when the electric field intensity of the first phase feeder is lower than the first field intensity threshold value and the electric field intensities of the second phase feeder and the third phase feeder are higher than the second field intensity threshold value is determined to be an occurrence moment of the fault, that is, a moment when a ground electric field significantly changes is the occurrence moment of the fault.

During practical implementation, after it is determined that the single-phase ground fault occurs in the distribution network, occurrence of the single-phase ground fault may be located. In an example, the single-phase ground fault may be located in the following manner:
phase current component signal waveforms of the three-phase feeders within a specific time period is acquired;
a waveform parameter of the phase current component signal waveforms of the three-phase feeders is extracted, the waveform parameter including at least one of: a phase or an amplitude; and
fault location is performed on the single-phase ground fault on the basis of the waveform parameter of the phase current component signal waveform.

In an implementation, the specific time period may be set to be a time period corresponding to a time period between moments before and after the occurrence moment of the fault, for example, a time period between three cyclic waves before and after the occurrence moment of the fault. Correspondingly, acquisition of the phase current component signal waveform of the three-phase feeders within the specific time period refers to acquisition of a phase current component signal waveform of a fault phase and phase current component signal waveforms of non-fault phases within the specific time period.

On the basis of the embodiment of the disclosure, during a practical application, a component of a power frequency load current may be removed (for example, numerical values acquired by acquisition points between three cyclic waves before the occurrence moment of the fault are synchronously subtracted from numerical values acquired by each acquisition moment of three cyclic waves after the occurrence moment of the failure, or a power frequency current signal is filtered by virtue of a band pass filter) according to a cyclic characteristic and frequency characteristic of a normal current to obtain the phase current component waveform of the fault phase caused by the single-phase ground fault, and the phase current component signal waveforms of the non-fault phases are obtained according to such a method.

On the basis of the embodiment of the disclosure, during practical implementation, a maximum value, average value, differential value, integral value and a combination thereof of waveform signals may be extracted, or a similarity coefficient between the phase current component waveforms may be calculated, analysis is performed, phase differences corresponding to the phase current component signal waveform of the fault phase and phase current component signal waveforms of the non-fault phases in the three-phase feeders may further be acquired, and when the acquired phase differences are consistent with a preset phase difference condition (for example, the phase differences are 180° , or the phase difference is between 135° and 225° XX), it is determined that the single-phase ground fault occurs at downstream of a current electric field intensity monitoring point;
and/or, amplitude differences between the phase current component signal waveform of the fault phase and phase current component signal waveforms of the non-fault phases in the three-phase feeders are acquired, and when the acquired amplitude differences are consistent with a preset amplitude difference condition (for example, an amplitude of the phase current component signal waveform of the fault phase is higher than amplitudes of the phase current component signal waveforms of the non-fault phases, and difference values exceed a preset threshold value, and for example, exceed twice of a sum of current components of the two phases), it is determined that the single-phase ground fault occurs at the downstream of the current electric field intensity monitoring point. During the practical application, the method further includes that: current difference values corresponding to a phase current component of the fault phase and phase current components of the non-fault phases in the three-phase feeders are acquired; and
when the current difference values meet a preset current difference condition (for example, corresponding to the same moment, the phase current component of the fault phase is lower than the phase current components of the non-fault phases at the corresponding moment, and difference values reach a preset threshold value, for example, 25% of a sum of the phase current components of the non-fault phases), it is determined that the single-phase ground fault does not occur at the downstream of the current electric field intensity monitoring point.

In such a manner, if a power distribution network fault detection device determines that the single-phase ground fault occurs at the downstream of the current monitoring point and a device at an adjacent downstream monitoring point determines that the single-phase ground fault does not occur at the downstream of the current monitoring point, it may be determined that the fault occurs between the two monitoring points (i.e. two distribution network fault detection devices).

In an example a duration of a local "phase electric field imbalance" condition may be synchronously monitored, that is, a fault removal condition within a time period (which may be set according to a practical requirement, for example, 30 seconds and 3 minutes) after occurrence of the single-phase ground fault is monitored to judge a specific type of the single-phase ground fault;
if the single-phase ground fault persistently exists within the time period, it is determined that the single-phase ground fault is a permanent single-phase ground fault;
if a number of times for which the single-phase ground fault occurs again after being removed within the time period exceeds a preset frequency threshold value (the frequency threshold value may be set according to the practical requirement, for example: 3 times), that is, the single-phase ground fault intermittently occurs and is automatically removed within the time period, it is determined that the single-phase ground fault is an intermittent single-phase ground fault; and
if a duration of the single-phase ground fault is smaller than a preset time threshold value (the time threshold value may be set according to the practical condition, for example: 0.2s), it is determined that the single-phase ground fault is a transient single-phase ground fault.

In an embodiment, when it is determined that the single-phase ground fault occurs at the downstream of the current electric field intensity monitoring point, the current electric field intensity monitoring point is located on a branch line of the distribution network and the single-phase ground fault is a permanent single-phase ground fault or an intermittent single-phase ground fault, a local switch is controlled to be in an off state; and
when it is determined that the single-phase ground fault occurs at the downstream of the current electric field intensity monitoring point, the current electric field intensity monitoring point is located on the branch line of the distribution network and the single-phase ground fault is a transient single-phase ground fault, a warning prompt is sent, for example, buzzing, warning text displaying and warning information reporting.

In an example when it is determined that the single-phase ground fault occurs at the downstream of the current electric field intensity monitoring point and the current electric field intensity monitoring point is located on a main line of the distribution network, a fault location result of an adjacent downstream electric field intensity monitoring point of the current electric field intensity monitoring point is acquired (the fault location result includes whether the single-phase ground fault is located at a downstream of the adjacent downstream electric field intensity monitoring point or not); and
when the fault location result represents that the single-phase ground fault does not occur at the downstream of the adjacent downstream electric field intensity monitoring point and the single-phase ground fault is a permanent single-phase ground fault or an intermittent single-phase ground fault, the local switch and a switch at the adjacent downstream electric field intensity monitoring point are controlled to be in the off state.

During the practical application, acquisition of the fault location result of the adjacent downstream electric field intensity monitoring point of the current electric field intensity monitoring point may be implemented through communication with the distribution network fault detection device at the adjacent downstream electric field intensity monitoring point or a main station. For example, a fault location result acquisition request is sent to the adjacent downstream distribution network fault detection device, or the request is sent to the main station, to obtain the returned fault location result.

During practical implementation, an indication or instruction of turning off the corresponding switch may be sent to the adjacent downstream distribution network fault detection device to control the switch at the adjacent downstream electric field intensity monitoring point to be in the off state.

In an example, when it is determined that the single-phase ground fault occurs at the downstream of the current electric field intensity monitoring point and does not occur at the downstream of the adjacent downstream electric field intensity monitoring point, it is determined that the single-phase ground fault occurs between the two monitoring points, and then it may be indicated that the single-phase ground fault occurs between the current electric field intensity monitoring point and the adjacent downstream electric field intensity monitoring point, for example, location result information is displayed through a display screen;
and/or, the location result of the single-phase ground fault is reported to the main station of the distribution network, the location result of the single-phase ground fault representing that the single-phase ground fault occurs between the current electric field intensity monitoring point and the adjacent downstream electric field intensity monitoring point.

In different embodiments, the location result of the single-phase ground fault (whether it occurs at the downstream of the current electric field intensity monitoring point or not) and/or the specific type of the single-phase ground fault (a permanent single-phase ground fault, an intermittent single-phase ground fault and a transient single-phase ground fault), after being obtained, may be reported to the main station of the distribution network to obtain a switch action instruction returned by the main station.

With application of the embodiment of the disclosure, single-phase ground fault detection is performed by virtue of phase electric fields, and single-phase ground fault location is performed by extracting a phase fault current, so that dependence on an electromagnetic voltage sensor and a capacitance voltage sensor is eliminated, a phenomenon of ferromagnetic resonance is avoided, and influence on safe and stable operation of a primary side of a power grid is eliminated; fault detection and location is performed by local signal acquisition as much as possible, so that massive information communication is avoided, and reliability is effectively improved; and electric field signals and current signals extracted in a frequency division manner are reasonably utilized, an adopted fault signature is prominent and obvious, and the single-phase ground fault is detected and located accurately, reliably and rapidly.

### Embodiment 1

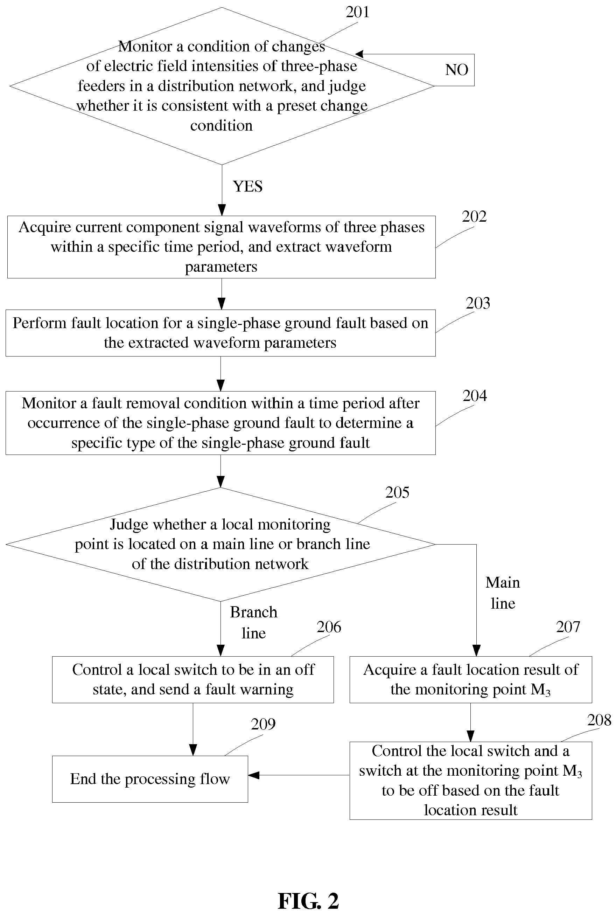

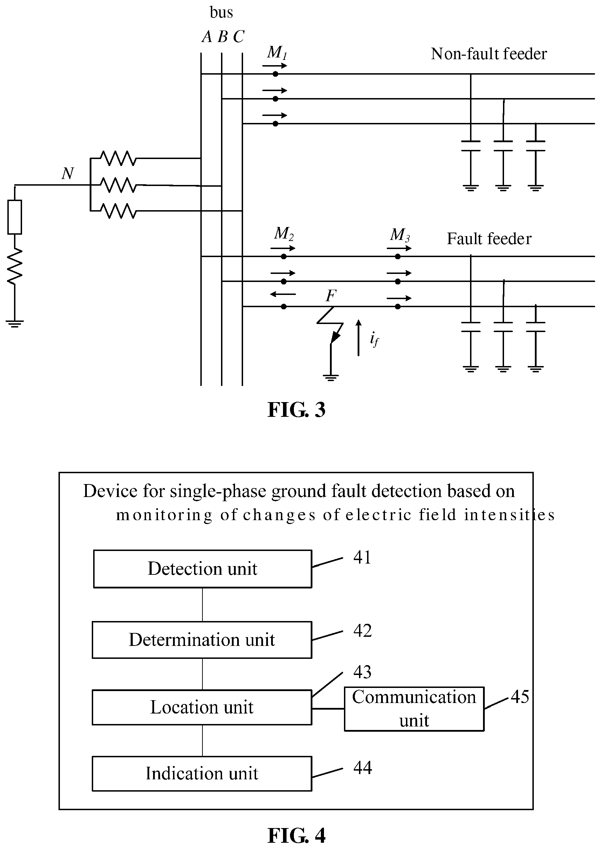

The embodiment of the disclosure provides a method for single-phase ground fault detection based on monitoring of changes of electric field intensities. FIG. 2 is an alternative flowchart of a method for single-phase ground fault detection based on monitoring of changes of electric field intensities to an embodiment of the disclosure. FIG. 3 is a schematic diagram of an alternative application scenario of a method for single-phase ground fault detection based on monitoring of changes of electric field intensities according to an embodiment of the disclosure. As shown in FIG. 3, multiple monitoring points, for example, M₁, M₂ and M₃, are distributed and arranged on three-phase feeders in a distribution network, and a device for single-phase ground fault detection based on monitoring of changes of electric field intensities is arranged at each monitoring point, and is configured to implement the method for single-phase ground fault detection based on monitoring of changes of electric field intensities of the embodiment of the disclosure. For example, the monitoring point M₂ is a local monitoring point, and in combination with FIG. 2 and FIG. 3, the method for single-phase ground fault detection based on monitoring of changes of electric field intensities in the embodiment of the disclosure includes the following steps.

In Step 201, a condition of changes of electric field intensities of the three-phase feeders in the distribution network is monitored, whether the changes of the electric field intensities are consistent with a preset change condition or not is judged, if YES, it is determined that a single-phase ground fault occurs in the distribution network and Step 202 is executed, otherwise Step 201 is executed.

Here, during a practical application, ground signals of three phases A, B and C may be picked up through an electric field sensor. In an implementation, when it is locally monitored that an electric field intensity of a first phase feeder is lower than a first field intensity threshold value (the first field intensity threshold value may be set according to a practical condition, and for example, is 50% of a normal electric field intensity of the feeder) and electric field intensities of a second phase feeder and a third phase feeder are higher than a second field intensity threshold value (the second field intensity threshold value is higher than the first field intensity threshold value, may be set according to the practical condition, and for example, is 1.5 times the normal electric field intensity of the feeder), it is determined that the single-phase ground fault occurs in the distribution network. That is, when it is recognized that an electric field of a certain phase in the three-phase feeders is significantly decreased and, meanwhile, the other two phases are significantly increased, the single-phase ground fault occurs in the distribution network. For example, when it is recognized that, in FIG. 3, a ground electric field of the phase C is significantly decreased and, meanwhile, ground electric fields of the two phases B and C are significantly increased, it is determined that a single-phase ground fault occurs in a power grid, the phase (i.e. the phase C) of which the ground electric field is significantly decreased is a fault phase, and a moment when a ground electric field significantly changes is an occurrence moment of the fault.

In Step 202, current component signal waveforms of three phases within a specific time period are acquired, and waveform parameters are extracted.

Here, during practical implementation, current component signal waveforms of the three phases A, B and C within a time period between moments before and after the occurrence moment of the fault may be acquired, and current signals of the three phases may be picked up through a current transformer. An implementation mode includes that: a component of a power frequency load current is removed (for example, numerical values acquired by acquisition points between three cyclic waves before the occurrence moment of the fault are synchronously subtracted from numerical values acquired by each acquisition point of three cyclic waves after the occurrence moment of the failure, or a power frequency current signal is filtered by virtue of a band pass filter) according to a cyclic characteristic and frequency characteristic of a normal current to obtain the current component signal waveforms of the three phases caused by the single-phase ground fault.

During the practical application, the extracted waveform parameters may include a phase and an amplitude; a signal maximum value, average value, differential value, integral value and a combination thereof in the phase current component signal waveforms may be extracted, or a similarity coefficient between the fault current component waveforms of the three phases may be calculated, and analysis is performed.

In Step 203, fault location is performed the single-phase ground fault on the basis of the extracted waveform parameters.

Here, the waveform parameters are analyzed to judge whether differences between a fault current component phase of the phase C and the other two phases at M₂ are 180° or not or whether the amplitude (which is, for example, 1.5 times those of the other two phases) of the phase C is significantly higher than the other two phases or not, and if YES, it is determined that the single-phase ground fault occurs at a downstream of the monitoring point M₂.

During the practical application, the method may further include that: current difference values between a phase current component of the phase C and phase current components of the phases A and B in the three-phase feeders are acquired; and
when the current difference values meet a preset current difference condition (for example, corresponding to the same moment, the phase current component of the fault phase is lower than the phase current components of the non-fault phases at the corresponding moment, and the difference values reach a preset threshold value, for example, the phase current component of the fault phase is 50% of the phase current components of the non-fault phases), it is determined that the single-phase ground fault does not occur at the downstream of the monitoring point M₂.

In the embodiment, it is determined that the fault occurs at the downstream of the monitoring point M₂. The distribution network fault detection devices at the monitoring points M₁ and M₃ determine that no single-phase ground fault occurs at their downstream by adopting the same determination manner.

In Step 204, a fault removal condition within a time period after occurrence of the single-phase ground fault is monitored to determine a specific type of the single-phase ground fault.

Here, during practical implementation, if the single-phase ground fault persistently exists within the time period (which is 5 minutes in the embodiment), it is determined that the single-phase ground fault is a permanent single-phase ground fault;
if a number of times for which the single-phase ground fault occurs again after being removed within the time period exceeds a preset frequency threshold value (the frequency threshold value may be set according to a practical requirement, for example: 3 times), that is, the single-phase ground fault intermittently occurs and is automatically removed within the time period, it is determined that the single-phase ground fault is an intermittent single-phase ground fault; and
if a duration of the single-phase ground fault is smaller than a preset time threshold value (the time threshold value may be set according to the practical condition, for example: 10s), it is determined that the single-phase ground fault is a transient single-phase ground fault.

In the embodiment, it is determined that the single-phase ground fault persistently exists within 5 minutes, and the single-phase ground fault is a permanent single-phase ground fault.

In Step 205, whether the local monitoring point is located on a main line or branch line of the distribution network or not is judged, if it is located on the branch line, Step 206 is executed, and if it is located on the main line, Step 207 is executed.

In Step 206, a local switch is controlled to be in an off state, a fault warning is sent, and Step 209 is executed.

In Step 207, a fault location result of the monitoring point M₃ is acquired.

During practical implementation, the result may be acquired through communication with the distribution network fault detection device at the monitoring point M₃ or the main station. For example, a fault location result acquisition request is sent to the distribution network fault detection device at M₃, or the request is sent to the main station, to obtain the returned fault location result. The fault location result includes whether the fault occurs at the downstream of the monitoring point M₃ or not. In the embodiment, the fault does not occur at the downstream of the monitoring point M₃, and thus it can be seen that the fault occurs between the monitoring point M₂ and the monitoring point M₃.

In Step 208, the local switch and a switch at the monitoring point M₃ are controlled to be turned off on the basis of the fault location result.

During practical implementation, an indication or instruction of turning off the corresponding switch may be sent to the adjacent downstream device for single-phase ground fault detection based on monitoring of changes of electric field intensities to control the switch at the adjacent downstream electric field intensity monitoring point to be in the off state.

In an embodiment, a notification about that the fault occurs between the monitoring point M₂ and the monitoring point M₃ may further be sent.

In Step 209, this processing flow is ended.

### Embodiment 2

The embodiment of the disclosure further provides a device for single-phase ground fault detection based on monitoring of changes of electric field intensities. As shown in FIG. 4, the device for single-phase ground fault detection based on monitoring of changes of electric field intensities includes a detection unit 41 and a determination unit 42.

The detection unit 41 is configured to monitor changes of electric field intensities of three-phase feeders in a distribution network; and

The determination unit 42 is configured to, when the changes of the electric field intensities of the three-phase feeders are consistent with a preset electric field intensity change condition, determine that a single-phase ground fault occurs in the distribution network.

In the embodiment, the determination unit 42 is further configured to, when it is recognized that, in the electric field intensities of the three-phase feeders, an electric field intensity of a first phase feeder is lower than a first field intensity threshold value and both electric field intensities of a second phase feeder and a third phase feeder are higher than a second field intensity threshold value, determine that the single-phase ground fault occurs in the distribution network.

Herein, the first field intensity threshold value is lower than the second field intensity threshold value.

In the embodiment, the device further includes a location unit 43.

The location unit 43 is configured to acquire phase current component signal waveforms of the three-phase feeders within a specific time period, extract a waveform parameter of the phase current component signal waveforms of the three-phase feeders, the waveform parameter comprising at least one of a phase or an amplitude, and perform fault location on the single-phase ground fault on the basis of the waveform parameter of the phase current component signal waveforms.

In the embodiment, the location unit 43 is further configured to perform at least one of the following: acquire a phase difference between a phase current component signal waveform of a fault phase and phase current component signal waveforms of non-fault phases among the three-phase feeders, and when the acquired phase differences are consistent with a preset phase difference condition, determine that the single-phase ground fault occurs at downstream of a current electric field intensity monitoring point; or acquire amplitude differences between the phase current component signal waveform of the fault phase and phase current component signal waveforms of the non-fault phases among the three-phase feeders, and when the acquired amplitude differences are consistent with a preset amplitude difference condition, determine that the single-phase ground fault occurs at the downstream of the current electric field intensity monitoring point.

In the embodiment, the location unit 43 is further configured to acquire current difference values between a phase current component of the fault phase and phase current components of the non-fault phases among the three-phase feeders, and when the current difference values meet a preset current difference condition, determine that the single-phase ground fault does not occur at the downstream of the current electric field intensity monitoring point.

In the embodiment, the location unit 43 is further configured to monitor a fault removal condition within a time period after occurrence of the single-phase ground fault; when the single-phase ground fault persistently exists within the time period, determine that the single-phase ground fault is a permanent single-phase ground fault; when a number of times for which the single-phase ground fault, after being removed, occurs again within the time period exceeds a preset frequency threshold value, determine that the single-phase ground fault is an intermittent single-phase ground fault; and when a duration of the single-phase ground fault is smaller than a preset time threshold value, determine that the single-phase ground fault is a transient single-phase ground fault.

In the embodiment, the location unit 43 is further configured to, when it is determined that the single-phase ground fault occurs at the downstream of the current electric field intensity monitoring point, the current electric field intensity monitoring point is located on a branch line of the distribution network and the single-phase ground fault is a permanent single-phase ground fault or an intermittent single-phase ground fault, control a local switch to be in an off state; or when it is determined that the single-phase ground fault occurs at the downstream of the current electric field intensity monitoring point, the current electric field intensity monitoring point is located on the branch line of the distribution network and the single-phase ground fault is a transient single-phase ground fault, send a warning prompt.

In the embodiment, the location unit 43 is further configured to, when it is determined that the single-phase ground fault occurs at the downstream of the current electric field intensity monitoring point and the current electric field intensity monitoring point is located on a main line of the distribution network, acquire a fault location result of an adjacent downstream electric field intensity monitoring point of the current electric field intensity monitoring point; or when the fault location result represents that the single-phase ground fault does not occur at downstream of the adjacent downstream electric field intensity monitoring point and the single-phase ground fault is a permanent single-phase ground fault or an intermittent single-phase ground fault, control the local switch and a switch at the adjacent downstream electric field intensity monitoring point to be in the off state.

In an embodiment, the device further includes an indication unit 44 and a communication unit 45.

The indication unit 44 is configured to indicate that the single-phase ground fault occurs between the current electric field intensity monitoring point and the adjacent downstream electric field intensity monitoring point.

The communication unit 45 is configured to report the location result of the single-phase ground fault to a main station of the distribution network, the location result of the single-phase ground fault representing that the single-phase ground fault occurs between the current electric field intensity monitoring point and the adjacent downstream electric field intensity monitoring point.

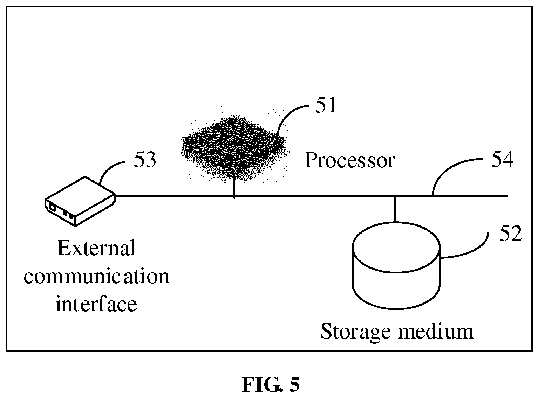

A not claimed embodiment of the disclosure further provides a device for single-phase ground fault detection based on monitoring of changes of electric field intensities, which includes: a memory, configured to store an executable program; and a processor, configured to execute the executable program stored in the memory to implement the abovementioned method for single-phase ground fault detection based on monitoring of changes of electric field intensities. In the embodiment, an example of the device for single-phase ground fault detection based on monitoring of changes of electric field intensities, which is a hardware device is shown in FIG. 5. The electronic device includes a processor 51, a storage medium 52 and at least one external communication interface 53, and the processor 51, the storage medium 52 and the external communication interface 53 are all connected through a bus 54.

It is to be noted that the device for single-phase ground fault detection based on monitoring of changes of electric field intensities provided by the embodiment belongs to the same concept with the method for single-phase ground fault detection based on monitoring of changes of electric field intensities embodiment, and details about its implementation process refer to the method embodiment, and will not be elaborated herein. Technical details not disclosed in the distribution network fault detection device embodiment of the disclosure refer to the descriptions about the method embodiment of the disclosure.

A not claimed embodiment of the disclosure further provides a storage medium, which stores an executable program, the executable program being executed by a processor to implement the abovementioned method for single-phase ground fault detection based on monitoring of changes of electric field intensities.

Those skilled in the art should know that the embodiment of the disclosure may be provided as a method, a system or an executable program product. Therefore, the disclosure may adopt a form of hardware embodiment, software embodiment and combined software and hardware embodiment. Moreover, the disclosure may adopt a form of executable program product implemented on one or more computer-available storage media (including, but not limited to, a disk memory and an optical memory) including computer-available program codes.

The disclosure is described with reference to flowcharts and/or block diagrams of the method, equipment (system) and executable program product according to the embodiment of the disclosure. It should be understood that each flow and/or block in the flowcharts and/or the block diagrams and combinations of the flows and/or blocks in the flowcharts and/or the block diagrams may be implemented by executable program instructions. These executable program instructions may be provided for a universal computer, a dedicated computer, an embedded processor or a processor of other programmable data processing equipment to generate a machine, so that a device for realizing a function specified in one flow or more flows in the flowcharts and/or one block or more blocks in the block diagrams is generated by the instructions executed through the computer or the processor of the other programmable data processing equipment.

These executable program instructions may also be stored in a computer-readable memory capable of guiding the computer or the other programmable data processing equipment to work in a specific manner, so that a product including an instruction device may be generated by the instructions stored in the computer-readable memory, the instruction device realizing the function specified in one flow or many flows in the flowcharts and/or one block or many blocks in the block diagrams.

These executable program instructions may further be loaded onto the computer or the other programmable data processing equipment, so that a series of operating steps are executed on the computer or the other programmable data processing equipment to generate processing implemented by the computer, and steps for realizing the function specified in one flow or many flows in the flowcharts and/or one block or many blocks in the block diagrams are provided by the instructions executed on the computer or the other programmable data processing equipment.

### INDUSTRIAL APPLICABILITY

According to the embodiments of the disclosure, the changes of the electric field intensities of the three-phase feeders in the distribution network are monitored; and when the changes of the electric field intensities of the three-phase feeders are consistent with the preset electric field intensity change condition, it is determined that the single-phase ground fault occurs in the distribution network. Therefore, the single-phase ground fault of the distribution network can be rapidly, accurately and reliably detected.

## Claims

1. A method for single-phase ground fault detection based on monitoring of changes of electric field intensities, comprising:
monitoring (101, 201) changes of electric field intensities of three-phase feeders in a distribution network; and
determining (102) that a single-phase ground fault occurs in the distribution network, when the changes of the electric field intensities of the three-phase feeders are consistent with a preset electric field intensity change condition;
wherein determining (102) that the single-phase ground fault occurs in the distribution network when the changes of the electric field intensities of the three-phase feeders are consistent with the preset electric field intensity change condition comprises:
when it is recognized that, among the electric field intensities of the three-phase feeders, an electric field intensity of a first phase feeder is lower than a first field intensity threshold value and both electric field intensities of a second phase feeder and a third phase feeder are higher than a second field intensity threshold value, determining (102) that the single-phase ground fault occurs in the distribution network,
wherein the first field intensity threshold value is lower than the second field intensity threshold value;
**characterized in that** after determining (102) that the single-phase ground fault occurs in the distribution network, the method further comprises:
acquiring (202) phase current component signal waveforms of the three-phase feeders within a specific time period;
extracting (202) a waveform parameter of the phase current component signal waveforms of the three-phase feeders, the waveform parameter comprising at least one of a phase or an amplitude; and
performing (203) fault location on the single-phase ground fault on the basis of the waveform parameter of the phase current component signal waveforms;
wherein performing (203) fault location on the single-phase ground fault on the basis of the waveform parameter of the phase current component signal waveform comprises at least one of the following:
acquiring, among the three-phase feeders, phase differences between a phase current component signal waveform of a fault phase and phase current component signal waveforms of non-fault phases, and when the acquired phase differences are consistent with a preset phase difference condition, determining that the single-phase ground fault occurs at downstream of a current electric field intensity monitoring point; or,
acquiring, among the three-phase feeders, amplitude differences between the phase current component signal waveform of the fault phase and phase current component signal waveforms of the non-fault phases, and when the acquired amplitude differences are consistent with a preset amplitude difference condition, determining that the single-phase ground fault occurs at the downstream of the current electric field intensity monitoring point;
further comprising:
monitoring (204) a fault removal condition within a time period after occurrence of the single-phase ground fault;
when the single-phase ground fault persistently exists within the time period, determining (204) that the single-phase ground fault is a permanent single-phase ground fault;
when a number of times for which the single-phase ground fault, after being removed, occurs again within the time period exceeds a preset frequency threshold value, determining (204) that the single-phase ground fault is an intermittent single-phase ground fault; or
when a duration of the single-phase ground fault is smaller than a preset time threshold value, determining (204) that the single-phase ground fault is a transient single-phase ground fault;
when it is determined that the single-phase ground fault occurs at the downstream of the current electric field intensity monitoring point, the current electric field intensity monitoring point is located on a branch line of the distribution network and the single-phase ground fault is a permanent single-phase ground fault or an intermittent single-phase ground fault, controlling a local switch to be in an off state;
when it is determined that the single-phase ground fault occurs at the downstream of the current electric field intensity monitoring point, the current electric field intensity monitoring point is located on the branch line of the distribution network and the single-phase ground fault is a transient single-phase ground fault, sending a warning prompt;
when it is determined that the single-phase ground fault occurs at the downstream of the current electric field intensity monitoring point and the current electric field intensity monitoring point is located on a main line of the distribution network, acquiring a fault location result of an adjacent downstream electric field intensity monitoring point of the current electric field intensity monitoring point; or
when the fault location result represents that the single-phase ground fault does not occur at the downstream of the adjacent downstream electric field intensity monitoring point and the single-phase ground fault is a permanent single-phase ground fault or an intermittent single-phase ground fault, controlling the local switch and a switch at the adjacent downstream electric field intensity monitoring point to be in the off state.

2. The method according to claim 1, wherein performing (203) fault location on the single-phase ground fault on the basis of the waveform parameter of the phase current component signal waveform comprises:
acquiring, among the three-phase feeders, current difference values between a phase current component of the fault phase and phase current components of the non-fault phases; and
when the current difference values meet a preset current difference condition, determining that the single-phase ground fault does not occur at the downstream of the current electric field intensity monitoring point.

3. The method according to claim 1, further comprising at least one of the following:
indicating that the single-phase ground fault occurs between the current electric field intensity monitoring point and the adjacent downstream electric field intensity monitoring point; or,
reporting the location result of the single-phase ground fault to a main station of the distribution network, the location result of the single-phase ground fault representing that the single-phase ground fault occurs between the current electric field intensity monitoring point and the adjacent downstream electric field intensity monitoring point.

4. A device for single-phase ground fault detection based on monitoring of changes of electric field intensities, comprising:
a detection unit (41), configured to monitor changes of electric field intensities of three-phase feeders in a distribution network; and
a determination unit (42), configured to, when the changes of the electric field intensities of the three-phase feeders are consistent with a preset electric field intensity change condition, determine that a single-phase ground fault occurs in the distribution network; wherein
the determination unit (42) is further configured to, when it is recognized that, in the electric field intensities of the three-phase feeders, an electric field intensity of a first phase feeder is lower than a first field intensity threshold value and both electric field intensities of a second phase feeder and a third phase feeder are higher than a second field intensity threshold value, determine that the single-phase ground fault occurs in the distribution network,
wherein the first field intensity threshold value is lower than the second field intensity threshold value;
**characterized in**
further comprising a location unit (43), configured to:
acquire phase current component signal waveforms of the three-phase feeders within a specific time period,
extract a waveform parameter of the phase current component signal waveforms of the three-phase feeders, the waveform parameter comprising at least one of a phase or an amplitude, and
perform fault location on the single-phase ground fault on the basis of the waveform parameter of the phase current component signal waveforms;
wherein the location unit (43) is further configured to perform at least one of the following:
acquire a phase difference between a phase current component signal waveform of a fault phase and phase current component signal waveforms of non-fault phases among the three-phase feeders, and when the acquired phase differences are consistent with a preset phase difference condition, determine that the single-phase ground fault occurs at downstream of a current electric field intensity monitoring point; or
acquire amplitude differences between the phase current component signal waveform of the fault phase and phase current component signal waveforms of the non-fault phases among the three-phase feeders, and when the acquired amplitude differences are consistent with a preset amplitude difference condition, determine that the single-phase ground fault occurs at the downstream of the current electric field intensity monitoring point, or
wherein the location unit (43) is further configured to: acquire current difference values between a phase current component of the fault phase and phase current components of the non-fault phases among the three-phase feeders, and when the current difference values meet a preset current difference condition, determine that the single-phase ground fault does not occur at the downstream of the current electric field intensity monitoring point;
wherein the location unit (43) is further configured to:
monitor a fault removal condition within a time period after occurrence of the single-phase ground fault,
when the single-phase ground fault persistently exists within the time period, determine that the single-phase ground fault is a permanent single-phase ground fault,
when a number of times for which the single-phase ground fault, after being removed, occurs again within the time period exceeds a preset frequency threshold value, determine that the single-phase ground fault is an intermittent single-phase ground fault, and
when a duration of the single-phase ground fault is smaller than a preset time threshold value, determine that the single-phase ground fault is a transient single-phase ground fault;
wherein the location unit (43) is further configured to:
when it is determined that the single-phase ground fault occurs at the downstream of the current electric field intensity monitoring point, the current electric field intensity monitoring point is located on a branch line of the distribution network and the single-phase ground fault is a permanent single-phase ground fault or an intermittent single-phase ground fault, control a local switch to be in an off state;
when it is determined that the single-phase ground fault occurs at the downstream of the current electric field intensity monitoring point, the current electric field intensity monitoring point is located on the branch line of the distribution network and the single-phase ground fault is a transient single-phase ground fault, send a warning prompt;
when it is determined that the single-phase ground fault occurs at the downstream of the current electric field intensity monitoring point and the current electric field intensity monitoring point is located on a main line of the distribution network, acquire a fault location result of an adjacent downstream electric field intensity monitoring point of the current electric field intensity monitoring point; or
when the fault location result represents that the single-phase ground fault does not occur at downstream of the adjacent downstream electric field intensity monitoring point and the single-phase ground fault is a permanent single-phase ground fault or an intermittent single-phase ground fault, control the local switch and a switch at the adjacent downstream electric field intensity monitoring point to be in the off state.

5. The device according to claim 4, further comprising:
an indication unit (44), configured to indicate that the single-phase ground fault occurs between the current electric field intensity monitoring point and the adjacent downstream electric field intensity monitoring point; and
a communication unit (45), configured to report the location result of the single-phase ground fault to a main station of the distribution network, the location result of the single-phase ground fault representing that the single-phase ground fault occurs between the current electric field intensity monitoring point and the adjacent downstream electric field intensity monitoring point.

## Patentansprüche

1. Verfahren zur einphasigen Erdschlusserkennung basierend auf dem Überwachen von Änderungen der Intensitäten des elektrischen Feldes, umfassend:
Überwachen (101, 201) von Änderungen der Intensitäten des elektrischen Feldes von dreiphasigen Zuleitungen in einem Verteilungsnetz; und
Bestimmen (102), dass ein einphasiger Erdschluss in dem Verteilungsnetz auftritt, wenn die Änderungen der Intensitäten des elektrischen Feldes der dreiphasigen Zuleitungen mit einer voreingestellten Bedingung zur Änderung der Intensitäten des elektrischen Feldes übereinstimmen;
wobei das Bestimmen (102), dass der einphasige Erdschluss in dem Verteilungsnetz auftritt, wenn die Änderungen der Intensitäten des elektrischen Feldes der dreiphasigen Zuleitungen mit der voreingestellten Bedingung zur Änderung der Intensitäten des elektrischen Feldes übereinstimmen, umfasst:
wenn erkannt wird, dass unter den Intensitäten des elektrischen Feldes der dreiphasigen Zuleitungen eine Intensität des elektrischen Feldes einer Zuleitung der ersten Phase niedriger als ein Schwellenwert der ersten Feldintensität ist und sowohl die Intensitäten des elektrischen Feldes einer Zuleitung der zweiten Phase als auch einer Zuleitung der dritten Phase höher als ein Schwellenwert der zweiten Feldintensität sind, Bestimmen (102), dass der einphasige Erdschluss im Verteilungsnetz auftritt,
wobei der Schwellenwert der ersten Feldintensität niedriger ist als der Schwellenwert der zweiten Feldintensität;
**dadurch gekennzeichnet, dass** nach dem Bestimmen (102), dass der einphasige Erdschluss im Verteilungsnetz auftritt, das Verfahren ferner umfasst:
Erfassen (202) von Wellenformen des Phasenstromkomponentensignals der dreiphasigen Zuleitungen innerhalb eines bestimmten Zeitraums;
Extrahieren (202) eines Wellenformparameters der Wellenformen des Phasenstromkomponentensignals der dreiphasigen Zuleitungen, wobei der Wellenformparameter wenigstens eine Phase oder eine Amplitude umfasst; und
Durchführen einer (203) Fehlerlokalisierung beim einphasigen Erdschluss auf der Grundlage des Wellenformparameters der Wellenformen des Phasenstromkomponentensignals;
wobei das Durchführen (203) einer Fehlerlokalisierung beim einphasigen Erdschluss auf der Grundlage des Wellenformparameters der Wellenformen des Phasenstromkomponentensignals wenigstens eines vom Folgenden umfasst:
Erfassen von Phasendifferenzen zwischen einer Wellenform des Phasenstromkomponentensignals einer Fehlerphase und Wellenform des Phasenstromkomponentensignals von Nicht-Fehlerphasen unter den dreiphasigen Zuleitungen und Bestimmen, wenn die erfassten Phasendifferenzen mit einer voreingestellten Phasendifferenzbedingung übereinstimmen, dass der einphasige Erdschluss stromabwärts eines aktuellen Punkts des Überwachens der Intensität des elektrischen Feldes auftritt; oder,
Erfassen von Amplitudendifferenzen zwischen der Wellenform des Phasenstromkomponentensignals der Fehlerphase und Wellenform des Phasenstromkomponentensignals der Nicht-Fehlerphasen unter den dreiphasigen Zuleitungen und Bestimmen, wenn die erfassten Amplitudendifferenzen mit einer voreingestellten
Amplitudendifferenzbedingung übereinstimmen, dass der einphasige Erdschluss stromabwärts des aktuellen Punkts des Überwachens der Intensität des elektrischen Feldes auftritt;
ferner umfassend:
Überwachen (204) einer Fehlerbeseitigungsbedingung innerhalb eines Zeitraums nach dem Auftreten des einphasigen Erdschlusses;
wenn der einphasige Erdschluss innerhalb des Zeitraums dauerhaft besteht, Bestimmen (204), dass der einphasige Erdschluss ein dauerhafter einphasiger Erdschluss ist;
wenn eine Anzahl von Malen, bei denen der einphasige Erdschluss nach dem Entfernen innerhalb des Zeitraums erneut auftritt, einen voreingestellten Frequenzschwellenwert überschreitet, Bestimmen (204), dass der einphasige Erdschluss ein intermittierender einphasiger Erdschluss ist; oder
wenn eine Dauer des einphasigen Erdschlusses kleiner als ein voreingestellter Zeitschwellenwert ist, Bestimmen (204), dass der einphasige Erdschluss ein vorübergehender einphasiger Erdschluss ist;
wenn bestimmt wird, dass der einphasige Erdschluss stromabwärts des aktuellen Punkts des Überwachens der Intensität des elektrischen Feldes auftritt, sich der aktuelle Punkt der Überwachung der Intensität des elektrischen Feldes auf einer Abzweigleitung des Verteilungsnetzes befindet und der einphasige Erdschluss ein dauerhafter einphasiger Erdschluss oder intermittierender einphasiger Erdschluss ist, Steuern eines lokalen Schalters, so dass er sich in einem ausgeschalteten Zustand befindet;
wenn bestimmt wird, dass der einphasige Erdschluss stromabwärts des aktuellen Punkts des Überwachens der Intensität des elektrischen Feldes auftritt, sich der aktuelle Punkt der Überwachung der Intensität des elektrischen Feldes auf einer Abzweigleitung des Verteilungsnetzes befindet und der einphasige Erdschluss ein vorübergehender einphasiger Erdschluss ist, Senden einer Warnmeldung;
wenn bestimmt wird, dass der einphasige Erdschluss stromabwärts des aktuellen Punkts des Überwachens der Intensität des elektrischen Feldes auftritt, und sich der aktuelle Punkt der Überwachung der Intensität des elektrischen Feldes auf einer Hauptleitung des Verteilungsnetzes befindet, Erfassen eines Ergebnisses der Fehlerortung eines benachbarten stromabwärtigen Punkts der Überwachung der Feldintensität des aktuellen Punkts der Überwachung der Feldintensität; oder
wenn das Ergebnis der Fehlerortung darstellt, dass der einphasige Erdschluss nicht stromabwärts des benachbarten stromabwärtigen Punkts zum Überwachen der Intensitäten des elektrischen Feldes auftritt und der einphasige Erdschluss ein dauerhafter einphasiger Erdschluss oder ein intermittierender einphasiger Erdschluss ist, Steuern des lokalen Schalters und eines Schalters am benachbarten stromabwärtigen Punkt der Überwachung der Intensität des elektrischen Feldes, so dass er sich im ausgeschalteten Zustand befindet.

2. Verfahren nach Anspruch 1, wobei das Durchführen (203) einer Fehlerlokalisierung beim einphasigen Erdschluss auf der Grundlage des Wellenformparameters der Wellenform des Phasenstromkomponentensignals umfasst:
Erfassen von Stromdifferenzwerten zwischen einer Phasenstromkomponente der Fehlerphase und Phasenstromkomponenten der Nicht-Fehlerphasen unter den dreiphasigen Zuleitungen; und
wenn die Stromdifferenzwerte eine voreingestellte Stromdifferenzbedingung erfüllen, Bestimmen, dass der einphasige Erdschluss nicht stromabwärts des aktuellen Punkts des Überwachens der Intensität des elektrischen Feldes auftritt.

3. Verfahren nach Anspruch 1, das ferner wenigstens eines vom Folgenden umfasst:
Anzeigen, dass der einphasige Erdschluss zwischen dem aktuellen Punkt der Überwachung der Intensität des elektrischen Feldes und dem benachbarten stromabwärtigen Punkt der Überwachung der Intensität des elektrischen Feldes auftritt; oder,
Melden des Ergebnisses der Lokalisierung des einphasigen Erdschlusses an eine Hauptstation des Verteilungsnetzes, wobei das Ergebnis der Lokalisierung des einphasigen Erdschlusses darstellt, dass der einphasige Erdschluss zwischen dem aktuellen Punkt der Überwachung der Intensität des elektrischen Feldes und dem benachbarten stromabwärtigen Punkt der Überwachung der Intensität des elektrischen Feldes auftritt.

4. Vorrichtung zur einphasigen Erdschlusserkennung basierend auf dem Überwachen von Änderungen der Intensitäten des elektrischen Feldes, umfassend:
eine Detektionseinheit (41), die konfiguriert ist, um Änderungen der Intensitäten des elektrischen Feldes von dreiphasigen Zuleitungen in einem Verteilungsnetz zu überwachen; und
eine Bestimmungseinheit (42), die konfiguriert ist, um zu bestimmen, dass ein einphasiger Erdschluss im Verteilungsnetz auftritt, wenn die Änderungen der Intensitäten des elektrischen Feldes der dreiphasigen Zuleitungen mit einer voreingestellten Bedingung zur Änderung der Intensitäten des elektrischen Feldes übereinstimmen; wobei
die Bestimmungseinheit (42) ferner konfiguriert ist, um zu bestimmen dass, wenn erkannt wird, dass in den elektrischen Feldintensitäten der dreiphasigen Zuleitungen eine elektrische Feldintensität einer Zuleitung der ersten Phase niedriger als ein Schwellenwert der ersten Feldintensität ist und sowohl die elektrischen Feldintensitäten einer Zuleitung der zweiten Phase als auch einer Zuleitung der dritten Phase höher als ein Schwellenwert der zweiten Feldintensität sind, der einphasige Erdschluss im Verteilungsnetz auftritt,
wobei der Schwellenwert der ersten Feldintensität niedriger ist als der Schwellenwert der zweiten Feldintensität;
**dadurch gekennzeichnet, dass** sie ferner eine Ortungseinheit (43) umfasst, die konfiguriert ist, um:
Wellenformen des Phasenstromkomponentensignals der dreiphasigen Zuleitungen innerhalb eines bestimmten Zeitraums zu erfassen;
einen Wellenformparameter der Wellenformen des Phasenstromkomponentensignals der dreiphasigen Zuleitungen zu extrahieren, wobei der Wellenformparameter wenigstens eine Phase oder eine Amplitude umfasst, und
eine Fehlerlokalisierung beim einphasigen Erdschluss auf der Grundlage des Wellenformparameters der Wellenformen des Phasenstromkomponentensignals auszuführen;
wobei die Ortungseinheit (43) ferner konfiguriert ist, um wenigstens eine der folgenden Aufgaben auszuführen:
Erfassen von Phasendifferenzen zwischen einer Wellenform des Phasenstromkomponentensignals einer Fehlerphase und Wellenform des Phasenstromkomponentensignals von Nicht-Fehlerphasen unter den dreiphasigen Zuleitungen und Bestimmen, wenn die erfassten Phasendifferenzen mit einer voreingestellten Phasendifferenzbedingung übereinstimmen, dass der einphasige Erdschluss stromabwärts eines aktuellen Punkts des Überwachens der Intensität des elektrischen Feldes auftritt; oder
Erfassen von Amplitudendifferenzen zwischen der Wellenform des Phasenstromkomponentensignals der Fehlerphase und Wellenform des Phasenstromkomponentensignals der Nicht-Fehlerphasen unter den dreiphasigen Zuleitungen und Bestimmen, wenn die erfassten Amplitudendifferenzen mit einer voreingestellten
Amplitudendifferenzbedingung übereinstimmen, dass der einphasige Erdschluss stromabwärts des aktuellen Punkts des Überwachens der Intensität des elektrischen Feldes auftritt;
wobei die Ortungseinheit (43) ferner konfiguriert ist, um: Stromdifferenzwerte zwischen einer Phasenstromkomponente der Fehlerphase und
Phasenstromkomponenten der Nicht-Fehlerphasen zwischen den dreiphasigen Zuleitungen zu erfassen und, wenn die Stromdifferenzwerte eine voreingestellte Stromdifferenzbedingung erfüllen, Bestimmen, dass der einphasige Erdschluss nicht stromabwärts des aktuellen Punkts des Überwachens der Intensität des elektrischen Feldes auftritt;
wobei: die Ortungseinheit (43) ferner zum Folgenden konfiguriert ist:
Überwachen einer Fehlerbeseitigungsbedingung innerhalb eines Zeitraums nach dem Auftreten des einphasigen Erdschlusses,
wenn der einphasige Erdschluss innerhalb des Zeitraums dauerhaft besteht, Bestimmen, dass der einphasige Erdschluss ein dauerhafter einphasiger Erdschluss ist,
wenn eine Anzahl von Malen, bei denen der einphasige Erdschluss nach dem Entfernen innerhalb des Zeitraums erneut auftritt, einen voreingestellten Frequenzschwellenwert überschreitet, Bestimmen, dass der einphasige Erdschluss ein intermittierender einphasiger Erdschluss ist; oder
wenn eine Dauer des einphasigen Erdschlusses kleiner als ein voreingestellter Zeitschwellenwert ist, Bestimmen, dass der einphasige Erdschluss ein vorübergehender einphasiger Erdschluss ist;
wobei: die Ortungseinheit (43) ferner zum Folgenden konfiguriert ist:
wenn bestimmt wird, dass der einphasige Erdschluss stromabwärts des aktuellen Punkts des Überwachens der Intensität des elektrischen Feldes auftritt, sich der aktuelle Punkt der Überwachung der Intensität des elektrischen Feldes auf einer Abzweigleitung des Verteilungsnetzes befindet und der einphasige Erdschluss ein dauerhafter einphasiger Erdschluss oder intermittierender einphasiger Erdschluss ist, Steuern eines lokalen Schalters, so dass er sich in einem ausgeschalteten Zustand befindet;
wenn bestimmt wird, dass der einphasige Erdschluss stromabwärts des aktuellen Punkts des Überwachens der Intensität des elektrischen Feldes auftritt, sich der aktuelle Punkt der Überwachung der Intensität des elektrischen Feldes auf einer Abzweigleitung des Verteilungsnetzes befindet und der einphasige Erdschluss ein vorübergehender einphasiger Erdschluss ist, Senden einer Warnmeldung;
wenn bestimmt wird, dass der einphasige Erdschluss stromabwärts des aktuellen Punkts des Überwachens der Intensität des elektrischen Feldes auftritt, und sich der aktuelle Punkt der Überwachung der Intensität des elektrischen Feldes auf einer Hauptleitung des Verteilungsnetzes befindet, Erfassen eines Ergebnisses der Fehlerortung eines benachbarten stromabwärtigen Punkts der Überwachung der Feldintensität des aktuellen Punkts der Überwachung der Feldintensität; oder
wenn das Ergebnis der Fehlerortung darstellt, dass der einphasige Erdschluss nicht stromabwärts des benachbarten stromabwärtigen Punkts zum Überwachen der elektrischen Feldintensitäten auftritt und der einphasige Erdschluss ein dauerhafter einphasiger Erdschluss oder ein intermittierender einphasiger Erdschluss ist, Steuern des lokalen Schalters und eines Schalters am benachbarten stromabwärtigen Punkt der Überwachung der Intensität des elektrischen Feldes, so dass er sich im ausgeschalteten Zustand befindet.

5. Die Vorrichtung nach Anspruch 4, ferner umfassend:
eine Anzeigeeinheit (44), die konfiguriert ist, um anzuzeigen, dass der einphasige Erdschluss zwischen dem aktuellen Punkt der Überwachung der Intensität des elektrischen Feldes und dem benachbarten stromabwärtigen Punkt der Überwachung der Intensität des elektrischen Feldes auftritt; und
eine Kommunikationseinheit (45), die konfiguriert ist, um das Ergebnis der Lokalisierung des einphasigen Erdschlusses an eine Hauptstation des Verteilungsnetzes zu melden, wobei das Ergebnis der Lokalisierung des einphasigen Erdschlusses darstellt, dass der einphasige Erdschluss zwischen dem aktuellen Punkt der Überwachung der Intensität des elektrischen Feldes und dem benachbarten stromabwärtigen Punkt der Überwachung der Intensität des elektrischen Feldes auftritt.

## Revendications

1. Procédé de détection de défauts monophasés à la terre, basé sur la surveillance de changements d'intensités de champ électrique, comprenant les étapes ci-dessous consistant à :
surveiller (101, 201) des changements d'intensités de champ électrique de lignes d'alimentation triphasées dans un réseau de distribution ; et
déterminer (102) qu'un défaut monophasé à la terre se produit dans le réseau de distribution, lorsque les changements d'intensités de champ électrique des lignes d'alimentation triphasées sont compatibles avec une condition de changement d'intensité de champ électrique prédéfinie ;
dans lequel l'étape consistant à déterminer (102) que le défaut monophasé à la terre se produit dans le réseau de distribution lorsque les changements des intensités de champ électrique des lignes d'alimentation triphasées sont compatibles avec la condition de changement d'intensité de champ électrique prédéfinie comprend l'étape ci-dessous consistant à :
lorsqu'il est reconnu que, parmi les intensités de champ électrique des lignes d'alimentation triphasées, une intensité de champ électrique d'une ligne d'alimentation d'une première phase est inférieure à une première valeur de seuil d'intensité de champ, et que les deux intensités de champ électrique d'une ligne d'alimentation d'une deuxième phase et d'une ligne d'alimentation d'une troisième phase sont supérieures à une seconde valeur de seuil d'intensité de champ, déterminer (102) que le défaut monophasé à la terre se produit dans le réseau de distribution ;
dans lequel la première valeur de seuil d'intensité de champ est inférieure à la seconde valeur de seuil d'intensité de champ ;
**caractérisé en ce que**, après avoir déterminé (102) que le défaut monophasé à la terre se produit dans le réseau de distribution, le procédé comprend en outre les étapes ci-dessous consistant à :
acquérir (202) des formes d'onde de signal de composante de courant de phase des lignes d'alimentation triphasées au cours d'une période de temps spécifique ;
extraire (202) un paramètre de forme d'onde des formes d'onde de signal de composante de courant de phase des lignes d'alimentation triphasées, le paramètre de forme d'onde comprenant au moins l'une parmi une phase et une amplitude ; et
mettre en œuvre (203) une localisation de défaut sur le défaut monophasé à la terre, sur la base du paramètre de forme d'onde des formes d'onde de signal de composante de courant de phase ;
dans lequel l'étape de mise en œuvre (203) de la localisation de défaut sur le défaut monophasé à la terre sur la base du paramètre de forme d'onde de la forme d'onde de signal de composante de courant de phase comprend au moins l'une des étapes ci-dessous consistant à :
acquérir, parmi les lignes d'alimentation triphasées, des différences de phase entre une forme d'onde de signal de composante de courant de phase d'une phase de défaut et des formes d'onde de signal de composante de courant de phase de phases sans défaut, et lorsque les différences de phase acquises sont conformes à une condition de différence de phase prédéfinie, déterminer que le défaut monophasé à la terre se produit en aval d'un point de surveillance d'intensité de champ électrique en cours ; ou
acquérir, parmi les lignes d'alimentation triphasées, des différences d'amplitude entre la forme d'onde de signal de composante de courant de phase de la phase de défaut et des formes d'onde de signal de composante de courant de phase des phases sans défaut, et lorsque les différences d'amplitude acquises sont conformes à une condition de différence d'amplitude prédéfinie, déterminer que le défaut monophasé à la terre se produit en aval du point de surveillance d'intensité de champ électrique en cours ;
comprenant en outre les étapes ci-dessous consistant à :
surveiller (204) une condition de suppression de défaut au cours d'une période de temps après l'occurrence du défaut monophasé à la terre ;
lorsque le défaut monophasé à la terre existe de manière persistante au cours de la période de temps, déterminer (204) que le défaut monophasé à la terre est un défaut monophasé à la terre permanent ;
lorsqu'un nombre de fois où le défaut monophasé à la terre, après avoir été supprimé, se produit à nouveau au cours de la période de temps dépasse une valeur de seuil de fréquence prédéfinie, déterminer (204) que le défaut monophasé à la terre est un défaut monophasé à la terre intermittent ; ou
lorsqu'une durée du défaut monophasé à la terre est inférieure à une valeur de seuil de temps prédéfinie, déterminer (204) que le défaut monophasé à la terre est un défaut monophasé à la terre transitoire ;
lorsqu'il est déterminé que le défaut monophasé à la terre se produit en aval du point de surveillance d'intensité de champ électrique en cours, que le point de surveillance d'intensité de champ électrique en cours est situé sur une ligne secondaire du réseau de distribution, et que le défaut monophasé à la terre est un défaut monophasé à la terre permanent ou un défaut monophasé à la terre intermittent, commander un commutateur local afin qu'il soit dans un état hors tension ;
lorsqu'il est déterminé que le défaut monophasé à la terre se produit en aval du point de surveillance d'intensité de champ électrique en cours, que le point de surveillance d'intensité de champ électrique en cours est situé sur une ligne secondaire du réseau de distribution, et que le défaut monophasé à la terre est un défaut monophasé à la terre transitoire, envoyer un message d'avertissement ;
lorsqu'il est déterminé que le défaut monophasé à la terre se produit en aval du point de surveillance d'intensité de champ électrique en cours et que le point de surveillance d'intensité de champ électrique en cours est situé sur une ligne principale du réseau de distribution, acquérir un résultat de localisation de défaut d'un point de surveillance d'intensité de champ électrique adjacent en aval du point de surveillance d'intensité de champ électrique en cours ; ou
lorsque le résultat de localisation de défaut indique que le défaut monophasé à la terre ne se produit pas en aval du point de surveillance d'intensité de champ électrique adjacent en aval et que le défaut monophasé à la terre est un défaut monophasé à la terre permanent ou un défaut monophasé à la terre intermittent, commander le commutateur local et un commutateur au niveau du point de surveillance d'intensité de champ électrique adjacent en aval afin qu'ils soient à l'état hors tension.

2. Procédé selon la revendication 1, dans lequel l'étape de mise en œuvre (203) de la localisation de défaut sur le défaut monophasé à la terre sur la base du paramètre de forme d'onde de signal de composante de courant de phase comprend les étapes ci-dessous consistant à :
acquérir, parmi les lignes d'alimentation triphasées, des valeurs de différence de courant entre une composante de courant de phase de la phase de défaut et des composantes de courant de phase des phases sans défaut ; et
lorsque les valeurs de différence de courant satisfont une condition de différence de courant prédéfinie, déterminer que le défaut monophasé à la terre ne se produit pas en aval du point de surveillance d'intensité de champ électrique en cours.

3. Procédé selon la revendication 1, comprenant en outre au moins l'une des étapes ci-dessous consistant à :
indiquer que le défaut monophasé à la terre se produit entre le point de surveillance d'intensité de champ électrique en cours et le point de surveillance d'intensité de champ électrique adjacent en aval ; ou
rendre compte du résultat de localisation du défaut monophasé à la terre à une station principale du réseau de distribution, le résultat de localisation du défaut monophasé à la terre indiquant que le défaut monophasé à la terre se produit entre le point de surveillance d'intensité de champ électrique en cours et le point de surveillance d'intensité de champ électrique adjacent en aval.

4. Dispositif pour une détection de défaut monophasé à la terre basée sur la surveillance de changements d'intensités de champ électrique, comprenant :
une unité de détection (41), configurée de manière à surveiller des changements d'intensités de champ électrique de lignes d'alimentation triphasées dans un réseau de distribution ; et
une unité de détermination (42) configurée de manière à, lorsque les changements des intensités de champ électrique des lignes d'alimentation triphasées sont compatibles avec une condition de changement d'intensité de champ électrique prédéfinie, déterminer qu'un défaut monophasé à la terre se produit dans le réseau de distribution ;
dans lequel l'unité de détermination (42) est en outre configurée de manière à, lorsqu'il est reconnu que, parmi les intensités de champ électrique des lignes d'alimentation triphasées, une intensité de champ électrique d'une ligne d'alimentation d'une première phase est inférieure à une première valeur de seuil d'intensité de champ, et que les deux intensités de champ électrique d'une ligne d'alimentation d'une deuxième phase et d'une ligne d'alimentation d'une troisième phase sont supérieures à une seconde valeur de seuil d'intensité de champ, déterminer que le défaut monophasé à la terre se produit dans le réseau de distribution ;
dans lequel la première valeur de seuil d'intensité de champ est inférieure à la seconde valeur de seuil d'intensité de champ ;
**caractérisé en ce qu'**il comprend en outre une unité de localisation (43) configurée de manière à :
acquérir des formes d'onde de signal de composante de courant de phase des lignes d'alimentation triphasées au cours d'une période de temps spécifique ;
extraire un paramètre de forme d'onde des formes d'onde de signal de composante de courant de phase des lignes d'alimentation triphasées, le paramètre de forme d'onde comprenant au moins l'une parmi une phase et une amplitude ; et
mettre en œuvre une localisation de défaut sur le défaut monophasé à la terre, sur la base du paramètre de forme d'onde des formes d'onde de signal de composante de courant de phase ;
dans lequel l'unité de localisation (43) est en outre configurée de manière à mettre en œuvre au moins l'une des étapes ci-dessous consistant à :
acquérir, parmi les lignes d'alimentation triphasées, une différence de phase entre une forme d'onde de signal de composante de courant de phase d'une phase de défaut et des formes d'onde de signal de composante de courant de phase de phases sans défaut, et lorsque les différences de phase acquises sont conformes à une condition de différence de phase prédéfinie, déterminer que le défaut monophasé à la terre se produit en aval d'un point de surveillance d'intensité de champ électrique en cours ; ou
acquérir, parmi les lignes d'alimentation triphasées, des différences d'amplitude entre la forme d'onde de signal de composante de courant de phase de la phase de défaut et des formes d'onde de signal de composante de courant de phase des phases sans défaut, et lorsque les différences d'amplitude acquises sont conformes à une condition de différence d'amplitude prédéfinie, déterminer que le défaut monophasé à la terre se produit en aval du point de surveillance d'intensité de champ électrique en cours ; ou
dans lequel l'unité de localisation (43) est en outre configurée de manière à : acquérir, parmi les lignes d'alimentation triphasées, des valeurs de différence de courant entre une composante de courant de phase de la phase de défaut et des composantes de courant de phase des phases sans défaut, et lorsque les valeurs de différence de courant satisfont une condition de différence de courant prédéfinie, déterminer que le défaut monophasé à la terre ne se produit pas en aval du point de surveillance d'intensité de champ électrique en cours ;
dans lequel l'unité de localisation (43) est en outre configurée de manière à :
surveiller une condition de suppression de défaut au cours d'une période de temps après l'occurrence du défaut monophasé à la terre ;
lorsque le défaut monophasé à la terre existe de manière persistante au cours de la période de temps, déterminer que le défaut monophasé à la terre est un défaut monophasé à la terre permanent ;
lorsqu'un nombre de fois où le défaut monophasé à la terre, après avoir été supprimé, se produit à nouveau au cours de la période de temps dépasse une valeur de seuil de fréquence prédéfinie, déterminer que le défaut monophasé à la terre est un défaut monophasé à la terre intermittent ; et
lorsqu'une durée du défaut monophasé à la terre est inférieure à une valeur de seuil de temps prédéfinie, déterminer que le défaut monophasé à la terre est un défaut monophasé à la terre transitoire ;
dans lequel l'unité de localisation (43) est en outre configurée de manière à :
lorsqu'il est déterminé que le défaut monophasé à la terre se produit en aval du point de surveillance d'intensité de champ électrique en cours, que le point de surveillance d'intensité de champ électrique en cours est situé sur une ligne secondaire du réseau de distribution, et que le défaut monophasé à la terre est un défaut monophasé à la terre permanent ou un défaut monophasé à la terre intermittent, commander un commutateur local afin qu'il soit dans un état hors tension ;
lorsqu'il est déterminé que le défaut monophasé à la terre se produit en aval du point de surveillance d'intensité de champ électrique en cours, que le point de surveillance d'intensité de champ électrique en cours est situé sur une ligne secondaire du réseau de distribution, et que le défaut monophasé à la terre est un défaut monophasé à la terre transitoire, envoyer un message d'avertissement ;
lorsqu'il est déterminé que le défaut monophasé à la terre se produit en aval du point de surveillance d'intensité de champ électrique en cours et que le point de surveillance d'intensité de champ électrique en cours est situé sur une ligne principale du réseau de distribution, acquérir un résultat de localisation de défaut d'un point de surveillance d'intensité de champ électrique adjacent en aval du point de surveillance d'intensité de champ électrique en cours ; ou
lorsque le résultat de localisation de défaut indique que le défaut monophasé à la terre ne se produit pas en aval du point de surveillance d'intensité de champ électrique adjacent en aval et que le défaut monophasé à la terre est un défaut monophasé à la terre permanent ou un défaut monophasé à la terre intermittent, commander le commutateur local et un commutateur au niveau du point de surveillance d'intensité de champ électrique adjacent en aval afin qu'ils soient à l'état hors tension.

5. Dispositif selon la revendication 4, comprenant en outre :
une unité d'indication (44), configurée de manière à indiquer que le défaut monophasé à la terre se produit entre le point de surveillance d'intensité de champ électrique en cours et le point de surveillance d'intensité de champ électrique adjacent en aval ; et
une unité de communication (45), configurée de manière à rendre compte du résultat de localisation du défaut monophasé à la terre, à une station principale du réseau de distribution, le résultat de localisation du défaut monophasé à la terre indiquant que le défaut monophasé à la terre se produit entre le point de surveillance d'intensité de champ électrique en cours et le point de surveillance d'intensité de champ électrique adjacent en aval.
